# EUROPEAN PATENT APPLICATION

(11) **EP 1 536 490 A1**
(43) Date of publication of application: **01.06.2005**
(21) Application number: 03795420.3
(22) Date of filing: 12.09.2003
(51) Int. Cl.: H01L 43/08, H01L 43/12, G01R 33/09, G11B 5/39

(54) **MAGNETORESISTANCE EFFECT ELEMENT AND PRODUCTION METHOD AND APPLICATION METHOD THEREFOR**

(30) Priority: 13.09.2002 JP 2002268541; 13.09.2002 JP 2002268542
(71) Applicant: MATSUSHITA ELECTRIC INDUSTRIAL CO., LTD., Kadoma-shi, Osaka 571-8501 (JP)
(72) Inventor: NISHIWAKI, Hideaki, Kadoma-shi, Osaka 571-0014 (JP); ONAKA, Kazuhiro, Nishinomiya-shi, Hyogo 663-8005 (JP); HAYASHI, Nobukazu, Neyagawa-shi, Osaka 572-0055 (JP)
(74) Representative: Grünecker, Kinkeldey, Stockmair & Schwanhäusser
(86) International application number: PCT/JP2003/011687
(87) International publication number: WO 2004/025745

(57) **Abstract**

A magneto-resistive element includes: a metal artificial lattice film (4) in which a magnetic thin film and a non-magnetic metal thin film are alternately laminated in at least two layers on a part of a substrate (1) and formed into a predetermined pattern; a first protective layer (5) covering the metal artificial lattice film (4); and a second protective layer (6) formed on the first protective layer (5). The residual stress of the first protective layer (5) is substantially zero. The second protective layer (6) is made of a material rejecting water. This structure can achieve a magneto-resistive element that has no hysteresis and small deterioration of the characteristics even at high temperatures, and has excellent heat resistance and corrosion resistance. Thus, this element can be used in sever environments, such as in an automobile.

## Description

### TECNICAL FIELD

The present invention relates to a magneto-resistive element, particularly to one employing a giant magneto-resistance effect, and to methods of manufacturing and using the magneto-resistive element.

### BACKGROUND ART

A magneto-resistive element is characterized by changing its resistance depending on the direction and strength of a magnetic field applied thereto. Examples of a sensor using such a magneto-resistive element include a rotation-detecting sensor. In this sensor, magneto-resistive elements having a bias magnet disposed underneath are connected in series, a voltage is applied thereto, a change in the voltage at the mid-point is detected by an external circuit, and the signals are processed, to detect a rotation speed of a rotating body.

Magneto-resistive elements include a Hall IC in which Hall devices and a control circuit are formed on a semiconductor substrate, a ferromagnetic thin film element, e.g. nickel-iron (Ni-Fe) alloys and nickel-cobalt (Ni-Co) alloys, and a semiconductor magneto-resistive element, e.g. indium antimonide (InSb). However, in recent years, to obtain a larger magneto-resistance effect, a giant magneto-resistive element (GMR element) structured so that magnetic thin films and non-magnetic metal thin films each several nanometers in thickness are alternately laminated has become to be used for a rotation-detecting sensor or position-detection sensor.

As such a magneto-resistive element, various kinds of structures are proposed other than the structure of lamination of magnetic films and non-magnetic metal thin films. Hereinafter, a brief description is provided of a method of manufacturing a magneto-resistive element made of a metal artificial lattice film structure in which the magnetic films and non-magnetic metal thin films are laminated.

First, magnetic thin films and non-magnetic metal thin films are laminated on a substrate by sputtering or other method. Then, a metal artificial lattice film having a predetermined pattern is formed by photolithography and etching processes. This metal artificial lattice film has an electrode for application of voltage formed at each end. At the center of the metal artificial lattice film, an electrode for extracting an electric potential at the mid-point is formed. Further, a protective layer is formed to cover the metal artificial lattice film having the electrodes. Thus, a magneto-resistive element is produced. When the magnetic thin films and non-magnetic metal thin films are set to appropriate thicknesses, adjacent magnetic thin films via a non-magnetic metal thin film are anti-ferromagnetically coupled. At this time, the magnetic thin films are magnetized in opposite directions. When a magnetic field is applied to the metal artificial lattice film in the direction parallel to its surface, the magnetic films are magnetized in the same direction as the applied electric field. Thus, the resistance of the metal artificial lattice film is reduced. Detecting a change in the resistance caused by the application of a magnetic field is used for a sensor.

Hereinafter, a description is provided of the operation principle of such a magneto-resistive element when it is used for a rotation-detecting sensor.

Disposed near a magnetic rotating body having projections and depressions at regular intervals on its circumference like a gear are metal artificial lattice films combined as a half bridge or full bridge, and a permanent magnet for providing a bias magnetic field. When the magnetic rotating body rotates in this state, the direction of the magnetic field of the permanent magnet changes according to the projections and depressions. Thus, the direction and magnitude of the magnetic field applied to the metal artificial lattice films change. This change changes the resistance of the metal artificial lattice films, and thus the voltage at the mid-point of the bridge. By processing the changes in voltage using an external processing circuit, pulse-like signals can be obtained and thus the rotation speed can be detected.

Now, with a great advance of the electronic control technique of an automobile, various kinds of sensors are required for controlling an automobile. Automobiles are used outdoors in severe environments. For this reason, when a magneto-resistive element is applied to an automobile, it must not deteriorate and its characteristics must be stable even in sever environments, such as in an engine room.

A magneto-resistive element employing a giant magneto-resistance effect is considered a prospective sensor for automobiles because it has a large resistance change rate by magnetic force. However, in order for a magneto-resistive element to maintain a large resistance change rate by magnetic force and ensure high reliability in high-temperature environments including an engine room, it is necessary to improve the stability of a magnetism-sensitive film directly exhibiting the magneto-resistance effect at high temperatures. For this purpose, improvements in the materials of the magnetism-sensitive film itself and its protective layers and the steps of producing them are important.

Various discussions are made on the magnetism-sensitive materials. For example, Japanese Patent Unexamined Publication No.H8-83937 discloses that a ferromagnetic thin film layer containing 5 to 40 atomic % of nickel (Ni), 30 to 95 atomic % of cobalt (Co), and iron (Fe) as the residue, a ferromagnetic thin film containing 24 to 35 atomic % of nickel (Ni), 80 to 90 atomic % of cobalt (Co), and iron (Fe) as the residue, or a ferromagnetic thin film layer containing 20 atomic % or less of nickel (Ni), 80 to 90 atomic % of cobalt (Co), and iron (Fe) as the residue is used as a magnetic thin film, to provide a larger resistance change rate by magnetic force in a spin valve type magneto-resistive element. This publication also describes that the use of such materials can increase the resistance change rate by magnetic force and corrosion resistance.

To improve the reliability of such a magneto-resistive element, discussions are made on the materials of a protective layer and the steps of production thereof. For example, Japanese Patent Unexamined Publication No. 2001-203407 discloses that polyimide is used as a protective layer in a metal artificial lattice type magneto-resistive element. However, this publication mentions nothing about the influence of polyimide on the characteristics of the magneto-resistive element.

Further, Japanese Patent Unexamined Publication No. H10-326919 discloses that polyimide is used as a protective layer in a magneto-resistive element in which a magnetism-sensitive film exhibiting a giant magneto-resistance effect is used. This publication also describes that changing the thickness of polyimide can change the stress exerted on the magnetic film (magneto-resistive film). This publication also describes that a thin film layer made of silicon dioxide (SiO₂), alumina (Al₂O₃), or other material is provided between the polyimide and the magnetic film (magneto-resistive film) to protect the magnetic film (magneto-resistive film) in two ways. However, decreasing the thickness of polyimide to reduce the stress on the magnetic film leads to a decrease in the corrosion resistance of the magnetic film (magneto-resistive film). This publication does not specifically mention the method of reducing the stress while providing a thickness for ensuring the corrosion resistance. In the method of protecting the magnetic film (magneto-resistive film) in two ways by providing a thin film layer made of silicon dioxide (SiO₂), alumina (Al₂O₃), or other material, the stress exerted by this thin film layer may vary the characteristics.

As for these problems, inventors of the present invention have found that, for magneto-resistive elements of conventional structures, the resistance change rate by magnetic force considerably decreases in high-temperature environments of approximately 150° in comparison with room temperature. The inventors also have found that storage or use of the magneto-resistive elements for extended period of time at such high temperatures changes the resistance with time.

### SUMMARY OF THE INVENTION

Based of the above knowledge, the present invention aims to provide a magneto-resistive element characterized by excellent heat resistance and a large resistance change rate by magnetic force.

According to one aspect of the present invention, there is provided a magneto-resistive element including: a substrate; a metal artificial lattice film in which a magnetic thin film and a non-magnetic metal thin film are alternately laminated in at least two layers on a part of this substrate and formed into a predetermined pattern; a first protective layer covering the metal artificial lattice film on the substrate; and a second protective layer formed on the first protective layer. The residual stress of the first protective layer is substantially zero. The second protective layer is made of a material rejecting water.

This structure can achieve a magneto-resistive element that has no hysteresis and no deterioration of characteristics even at high temperatures of approximately 150°, and has excellent heat resistance. Because the magneto-resistive element also has excellent corrosion resistance, it can be used in sever environments, such as in an automobile.

Further, in the magneto-resistive element of the present invention of the above structure, the magnetic thin film is made of an alloy containing nickel (Ni), iron (Fe) and cobalt (Co), and the non-magnetic metal thin film is made of cupper (Cu) or silver (Ag). This structure can increase the resistance change rate by magnetic force and achieve a magneto-resistive element capable of providing sufficient output.

According to another aspect of the present invention, there is provided a magneto-resistive element including: a substrate, a metal artificial lattice film in which a magnetic thin film and a non-magnetic metal thin film are laminated in at least two layers on a part of this substrate and formed into a predetermined pattern; and a protective layer covering the metal artificial lattice film on the substrate. The magnetic thin film is an alloy film made of nickel (Ni), iron (Fe), and cobalt (Co). As for the percentage composition of the materials based on the number of atoms, nickel (Ni) ranges from 1 to 5 atomic%, cobalt (Co) ranges from 50 to 95 atomic %, and the residue is iron.

This structure can prevent deterioration of the resistance change rate by magnetic force and a change in characteristics with time even at high temperatures. It is considered that a small percentage composition of nickel (Ni) can inhibit diffusion of nickel (Ni) likely to occur at high temperatures.

Further, in the magneto-resistive element of the present invention of the above structure, the magnetic thin film is an alloy film having a composition ratio based on the number of atoms of nickel (Ni): cobalt (Co): iron (Fe) = 4: 90: 6. This structure can achieve a magneto-resistive element that has no hysteresis caused by the magnetic thin film and has excellent heat resistance and stability at high temperatures.

Further, in the magneto-resistive element of the present invention of the above structure, the non-magnetic metal thin film is made of cupper (Cu) or silver (Ag). This structure can increase a resistance change rate by magnetic force and achieve a magneto-resistive element capable of providing sufficient output.

Further, in the magneto-resistive element of the present invention, the protective layer includes a first protective layer formed on the substrate including the metal artificial lattice film, and a second protective layer formed on the first protective layer. The residual stress of the first protective layer is substantially zero. The second protective layer is made of a material rejecting water. This structure can achieve a magneto-resistive element that has excellent heat resistance and corrosion resistance and no deterioration of the characteristics caused by hysteresis.

Further, in the magneto-resistive element of the present invention, the first protective layer is made of one of silicon monoxide (SiO), silicon dioxide (SiO₂), silicon nitride (SiNx), and silicon oxynitride (SiON), and the second protective layer is made of polyimide. This structure can achieve a magneto-resistive element that has excellent heat resistance and corrosion resistance and no deterioration of the characteristics cause by hysteresis.

Further, in the magneto-resistive element of the present invention, the magnetic strain of the magnetic thin film is zero. This prevents generation of hysteresis caused by the magnetic thin film and achieves a magneto-resistive element having stable characteristics even at high temperatures.

Further, in the magneto-resistive element of the present invention, the substrate is made of ceramics. This can achieve an inexpensive magneto-resistive element suitable for use at high temperatures.

Further, in the magneto-resistive element of the present invention, the substrate is a glazed ceramic substrate in which a glass is glazed, and the metal artificial lattice film is formed on the glass layer. This structure can provide a ceramic substrate having excellent surface smoothness. For this reason, when a metal artificial lattice film is formed on the ceramic substrate, variations in characteristics are small and production yield can be improved.

Further, in the magneto-resistive element of the present invention, the amount of sodium ions (Na⁺), potassium ions (K⁺), and chlorine ions (Cl⁻) contained in the glass layer is up to 10 ppm each. This content can prevent changes in the resistance and magnetic characteristics of the metal artificial lattice film caused by the entry of these ions.

Further, in the magneto-resistive element of the present invention, the amount of sodium ions (Na⁺), potassium ions (K⁺), and chlorine ions (Cl⁻) contained in the first protective layer is up to 10 pmm each. This content can prevent changes in the resistance and magnetic characteristics of the metal artificial lattice film caused by the entry of these ions.

A method of manufacturing a magneto-resistive element of the present invention includes the steps of: forming a metal artificial lattice film having a predetermined pattern in which a magnetic thin film and a non-magnetic metal thin film are alternately laminated in at least two layers on a part of a substrate; forming a first protective layer covering the artificial lattice film on the substrate and having a residual stress of substantially zero; and forming a water-rejecting second protective layer on the first protective layer. This method can produce a magneto-resistive element having excellent corrosion resistance and no hysteresis caused by the protective layers.

Further, in the method of manufacturing a magneto-resistive element, the magnetic thin film constituting the metal artificial lattice film is an alloy made of nickel (Ni), cobalt (Co), and iron (Fe). As for the percentage composition based on the number of atoms, nickel (Ni) ranges from 1 to 5 atomic%, cobalt (Co) ranges from 50 to 95 atomic %, and the residue is iron. The non-magnetic metal film is made of cupper (Cu) or silver (Ag). The manufacturing method includes the step of laminating the magnetic thin film and the non-magnetic metal film alternately. This method can provide a magneto-resistive element having excellent heat resistance and corrosion resistance and no hysteresis caused by at least the first protective layer.

Further, in the method of manufacturing a magneto-resistive element of the present invention, the step of forming the first protective layer includes forming one of silicon monoxide (SiO), silicon dioxide (SiO₂), silicon nitride (SiNx), and silicon oxynitride (SiON) by sputtering or physical vapor deposition process with a temperature of the substrate set in the range of 200 to 250°C. This can provide a magneto-resistive element having excellent corrosion resistance and no hysteresis caused by a protective layer, by a mass-producing film-forming method.

Further, the magneto-resistive element of the present invention is used in environments of at least 150°C. For the magneto-resistive element of the present invention, even at high temperatures, a rate of the change in resistance equivalent to that at room temperature can be obtained, and a change in the characteristics of the artificial lattice film with time can be minimized.

A method of using a magneto-resistive element of the present invention is a method of using a magneto-resistive element in environments of at least 150°C. The magneto-resistive element of the present invention has a small decrease in the resistance change rate by magnetic force even at high temperatures, and can be used stably.

### BRIEF DESCRIPTION OF THE DRAWINGS

Fig. 1A is a plan view of a magneto-resistive element of an exemplary embodiment of the present invention.
Fig. 1B is a sectional view taken on line A-A of Fig. 1A.
Fig. 2 is a sectional view for illustrating a detailed structure of a metal artificial lattice film in the magneto-resistive element of the exemplary embodiment.
Fig. 3 is a schematic diagram showing a magneto-resistive element in which four metal artificial lattice films of the exemplary embodiment form a bridge circuit structure.

### DETAILED DESCRIPTION OF A PREFERRED EMBODIMENT

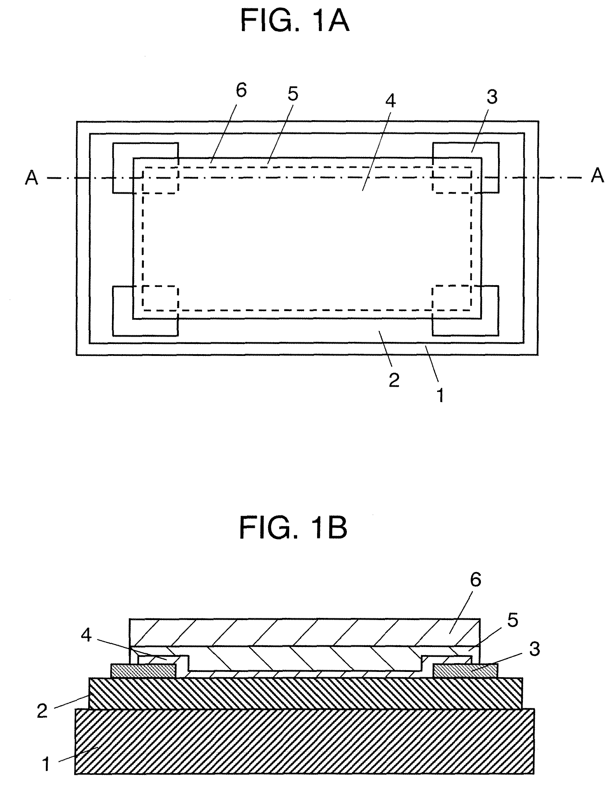

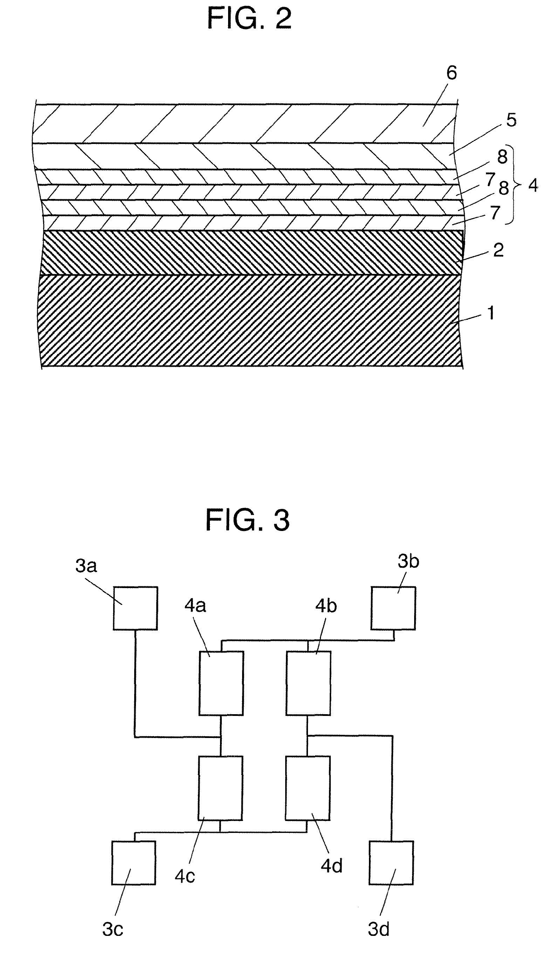

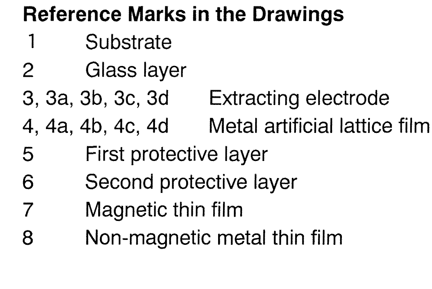

Hereinafter, an exemplary embodiment of the present invention is described with reference to the accompanying drawings. Fig. 1A is a plan view of a magneto-resistive element of the exemplary embodiment of the present invention. Fig. 1B is a sectional view taken on line A-A of Fig. 1A. Fig. 2 is a sectional view for illustrating a detailed structure of a metal artificial lattice film part in the magneto-resistive element of Figs. 1A and 1B.

A magneto-resistive element of the exemplary embodiment is structured to use a metal artificial lattice film in which magnetic films and non-magnetic films are laminated, as a magnetism-sensitive film. Onto one side of plate-lake substrate 1, glass layer 2 is glazed. Examples of this substrate 1 include ceramics made by sintering oxide powder, nitride powder, or the like, e.g. alumina ceramics, zirconia ceramics, and glass-alumina mixed ceramics. Further, as substrate 1, a silicon wafer, glass plate, quarts plate, or a ceramic plate compactly sintered to a mirror surface can also be used. However, because silicon is not an insulator, particularly in application at high temperatures, such as in an automobile, a decrease in the resistance of a substrate deteriorates the magneto-resistance effect. Thus, an insulating layer must be provided. Alumina ceramics is a preferable substrate, because it can provide a smooth surface by glazing a glass layer and is inexpensive.

Used for glass layer 2 to be glazed are materials that are generally used for glazing onto a ceramic surface and contain no alkali or chlorine (Cl), such as lead borosilicate glass, and borosilicate glass containing no alkali or lead.

Four extracting electrodes 3 are provided on glass layer 2 on substrate 1. Four extracting electrodes 3 are partially in electrical communication with metal artificial lattice film 4 and serve as terminals for connection to an external device (not shown). For these extracting electrodes 3, nichrome (NiCr) is preferably used. However, materials generally used as a wiring conductor, such as gold (Au), cupper (Cu), and nickel (Ni), can also be used.

Metal artificial lattice film 4 is formed in the shape of strip on glass layer 2 and a part of the surfaces of extracting electrodes 3, as shown in the drawings. Metal artificial lattice film 4 is electrically connected to respective extracting electrodes 3 provided at four corners. Incidentally, the connection structure of the exemplary embodiment is called a bridge circuit. The detection method is described as follows. A voltage is applied across two electrodes 3 on a diagonal line and differential output between the remaining two electrodes 3 is obtained as a voltage, so that a change in magnetic field is detected.

As shown in Fig. 2, this metal artificial lattice film 4 is structured so that magnetic thin films 7 and non-magnetic metal thin films 8 are laminated. In metal artificial lattice film 4 in the magneto-resistive element of this exemplary embodiment, two magnetic thin films 7 and two non-magnetic metal thin films 8 are laminated to form a four-layer structure. However, the number of laminated layers is not limited to this structure. Three layers or more of each film can be laminated and approximately ten layers are preferable for increasing a resistance change rate by magnetic force.

Magnetic thin film 7 is an alloy made of nickel (Ni), iron (Fe), and cobalt (Co). As for the percentage composition represented by atomic %, cobalt (Co) ranges from 50 to 95 atomic %, nickel (Ni) ranges from 1 to 5 atomic%, and the residue is iron. This composition is preferable in that it can increase a resistance change rate by magnetic force and resistance corrosion. More preferably, nickel (Ni) ranges from 1 to 4 atomic %. This nickel (Ni) composition range further improves a change in characteristics with time. It is considered that this composition can inhibit diffusion of nickel (Ni) in high-temperature environments. Further, it is preferable that this percentage composition is set to a condition where magnetic strain is zero. It is more preferable that the composition ratio based on the number of atoms is nickel (Ni): iron (Fe): cobalt (Co) = 4: 6: 90. At this composition ratio, magnetic strain is zero, a resistance change rate by magnetic force is large, and the heat resistance is drastically improved.

Preferably, cupper (Cu) or silver (Ag) is used for non-magnetic metal thin film 8. These magnetic thin film 7 and non-magnetic metal thin film 8 are laminated and shaped to a predetermined pattern, to form metal artificial lattice film 4.

First protective layer 5 is formed of one material selected from silicon monoxide (SiO), silicon dioxide (SiO₂), silicon nitride (SiNx), and silicon oxynitride (SiON) to cover metal artificial lattice film 4. This first protective layer 5 is formed by setting an appropriate temperature condition in production so that the residual stress thereof is zero. Second protective layer 6 is formed on first protective layer 5. Suitable material is polyimide; however, any organic material that can be used for a surface protective layer of a semiconductor can be used. As shown in the drawings, first protective layer 5 and second protective layer 6 are formed to cover substantially metal artificial lattice film 4 only. Forming in this manner can further reduce the influence of the stress.

The effect of a protective layer of a two-layer structure is described. In automobile applications, it is required that the magneto-resistive element should endure severe environments. However, it has been found that, under such a condition, a protective layer structured of polyimide, which has conventionally been used, has excellent heat resistance but the hysteresis generated in the magneto-resistive element cannot provide a desired resistance change by magnetic force. It has also been found that this phenomenon occurs even when metal artificial lattice film 4 is produced under a condition where its magnetic strain is zero so that metal artificial lattice film 4 itself has no hysteresis. Investigations show that this is because residual stress is created while polyimide is cured and metal artificial lattice film 4 is influenced by this stress.

When silicon dioxide (SiO₂), for example, is formed by sputtering or physical vapor deposition as first protective layer 5, compressive stress is generally created. However, the inventors have found that setting the substrate temperature from 200 to 250° in forming the layer can make the residual stress to zero. As a result, the stress exerted on metal artificial lattice film 4 can be made to zero. When polyimide, for example, is used for second protective layer 2, it creates stress while being cured. However, this stress is absorbed by first protective layer 5 and has substantially no influence on metal artificial lattice film 4. As a result, hysteresis caused by the protective layers can be eliminated.

Now, the description of "makes the stress substantially to zero" means that when stress is measured by an ordinary method of measuring stress, e.g. measuring a warp in a substrate to calculate a stress, the stress is substantially zero. This description also means that the magnitude of the stress is such that a metal artificial lattice film has no hysteresis.

For second protective layer 6, polyimide, for example, can be used. Thus, the second protective layer can fully protect metal artificial lattice film 4 and ensure the reliability of the magneto-resistive element even in high-temperature and high-humidity environments, such as in an automobile.

Next, a description is provided of a method of manufacturing a magneto-resistive element of this exemplary embodiment.

Substrate 1 in which glass frit is glazed onto the surface of ceramics, e.g. alumina, to form glass layer 2 is prepared. On glass layer 2 on this substrate 1, extracting electrodes 3 are formed by a deposition process using a mask to provide the pattern shown in the drawings. When a pattern of extracting electrodes 3 has a complicated shape, a predetermined pattern can be obtained by depositing a thin film for forming extracting electrodes on the entire surface without using a mask, and performing photolithography and etching processes. Alternatively, a thin film for forming extracting electrodes can be made by sputtering.

Next, magnetic thin films 7 and non-magnetic metal thin films 8 are alternately laminated by sputtering so as to have a predetermined thickness and overlap with a part of extracting electrodes 3 on glass layer 2. If the total number of laminated layers is approximately 10, a sufficient resistance change rate by magnetic force can be obtained. Thus, metal artificial lattice film 4 is laminated and formed into a predetermined shape. Metal artificial lattice film 4 is not formed on the entire surface of glass layer 2, but must be formed into a predetermined pattern. As forming a pattern, so-called mask film-forming method can be used. In this method, when magnetic thin films 7 and non-magnetic metal films 8 are formed, a mask is used to form these thin films into a predetermined pattern. Alternatively, after magnetic thin films 7 and non-magnetic metal thin films 8 are laminated on glass layer 2 predetermined times, these films can be etched into a predetermined pattern by photolithography and etching processes. The etching methods include ion milling as well as wet etching, and dry etching.

Next, first protective layer 5 is formed. The method includes forming the layer using one material selected from silicon monoxide (SiO), silicon dioxide (SiO₂), silicon nitride (SiNx), and silicon oxynitride (SiON) by sputtering or physical vapor deposition. During forming the layer, the substrate temperature is set in the range of 200 to 250°C. This can make the internal residual stress to zero.

Thereafter, second protective layer 6 is formed on first protective layer 5. As for second protective layer 6, applying polyimide resin, for example, by spin coating, and heating at 300°C to cure can provide a structure having polyimide as a protective layer. By such a manufacturing method, a magneto-resistive element of this exemplary embodiment can be produced.

Hereinafter, the operation of this magneto-resistive element is described. Metal artificial lattice film 4 is characterized in that its electrical resistance is changed by the direction and magnitude of a magnetic field applied thereto. Therefore, when the direction and magnitude of a magnetic field is changed by the position of a member to be detected, the electrical resistance of metal artificial lattice film 4 changes according to the position of the member to be detected. As a result, the position of the member can be detected.

In actual applications, in many cases, at least four metal artificial lattice films 4 are structured as a bridge circuit to prevent the influence of variations in the resistance in no magnetic field and a change in the resistance caused by temperature. Alternatively, a half bridge circuit in which two metal artificial lattice films 4 are connected in series and an electric potential at the mid-point is obtained can be used.

Fig. 3 is a diagram showing a magneto-resistive element in which four such metal artificial lattice films are made into a bridge circuit structure. With reference to Fig. 3, one end of each of metal artificial lattice films 4a and 4b is connected to extracting electrode 3b in common. Similarly, one end of each of metal artificial lattice films 4c and 4d is connected to extracting electrode 3c in common. The other end of each of metal artificial lattice films 4a and 4c are connected to extracting electrode 3a in common. Similarly, the other end of each of metal artificial lattice films 4b and 4d are connected to extracting electrode 3d in common. By connecting in this manner, a magneto-resistive element having a bridge circuit is produced. In production of this magneto-resistive element, four metal artificial lattice films 4 are disposed on glass layer 2 and these films are electrically connected by a predetermined wiring pattern. At this time, using the same material as extracting electrodes for the wiring pattern can achieve effective production. Because such a bridge circuit structure can cancel variations caused by temperature and variations in resistance, accuracy and temperature stability can drastically be improved.

As described above, a magneto-resistance element of this exemplary embodiment has a large resistance change rate by magnetic force and no hysteresis even in a high-temperature state of approximately 150°C, and thus can be used in severe environments, such as the engine room of an automobile.

Incidentally, when a rigid body like alumina is used as a substrate, even in application of external force to the substrate in use, the substrate absorbs the external force and thus application of stress to a metal artificial lattice film can be prevented. Now, "rigid body" is used as a term opposite to "flexible body", and means a body in which internal deformation caused by external force in ordinary use is negligibly small in a practical point of view.

The thickness of a glass layer to be glazed is not specifically limited when a smooth surface can be obtained. For general ceramics, such as alumina, a thickness of at least 10 µm is necessary for providing a smooth surface, because irregularity of the surface is relatively large. Actually, magneto-resistive elements having substrates with glass layers of different thicknesses were produced. Then, pressure cooker and bias tests (PCBTs) were conducted on the magneto-resistive elements in a high-temperature and high-humidity environment at a temperature of 121°C, a humidity of 80%, and 2 atmospheric pressures, to evaluate the characteristics of deterioration of resistance change rates by magnetic force. As a result, it has been found that a thickness of at least 10 µm can prevent deterioration. On the other hand, a thicker glass layer not only decreases productivity but increases stress, thus causing a warp in the substrate. For this reason, a thicker glass layer is not preferable. Based on these results, it is preferable that the thickness of a glass layer ranges from approximately 10 to 40 µm. Further, when variations in production are taken into account, it is more preferable that the thickness is at least 20 µm.

Further, it has been found that when sodium ions (Na⁺), potassium ions (K⁺), and chlorine ions (Cl⁻) are contained in a glass layer, the ions diffuse in a metal artificial lattice film, combine with elements therein, and change the characteristics thereof particularly at high temperatures. The upper limit of each content is obtained by experiments. It has been found that the content up to 10 ppm each can prevent the deterioration of the resistance change rate by magnetic force under practical conditions at approximately 150°C.

When a silicon wafer is used as substrate 1, it is necessary to select a material and film-forming method with which sodium ions (Na⁺), potassium ions (K⁺), and chlorine ions (Cl⁻) contained in an insulating layer to be formed on the surface of the substrate can be up to 10 ppm. When metal artificial lattice film 4 is directly formed on a glass plate, quarts plate, or mirror-surface-like ceramic plate as substrate 1, it is necessary that sodium ions (Na⁺), potassium ions (K⁺), and chlorine ions (Cl⁻) contained in theses materials are up to 10ppm each. In other words, sodium ions (Na⁺), potassium ions (K⁺), and chlorine ions (Cl⁻) contained in substrate 1 or glass layer 2 in contact with metal artificial lattice film 4 may be kept up to 10 ppm each.

Similarly, when sodium ions (Na⁺), potassium ions (K⁺), and chlorine ions (Cl⁻) are contained in a first protective layer, the ions diffuse in a metal artificial lattice film, combine with elements therein, and change the characteristics thereof particularly at high temperatures. It has also been found that each content may be kept up to 10 ppm.

Moreover, when sodium ions (Na⁺), potassium ions (K⁺), and chlorine ions (Cl⁻) contained both in a glass layer and a first protective layer are up to 10 ppm each, deterioration of characteristics can further be prevented. Further, when entry of sodium ions (Na⁺), potassium ions (K⁺), and chlorine ions (Cl⁻) by contamination during manufacturing process is prevented, the characteristics can further be stabilized.

Incidentally, when a protective layer has a single-layer structure instead of the two-layer structure of this exemplary embodiment, sodium ions (Na⁺), potassium ions (K⁺), and chlorine ions (Cl⁻) contained in this only one layer may be kept up to 10 ppm each. Similarly, when a protective layer structured of three layers or more, sodium ions (Na⁺), potassium ions (K⁺), and chlorine ions (Cl⁻) contained in at least one protective layer in contact with metal artificial lattice film 4 may be kept up to 10 ppm each . In other words, sodium ions (Na⁺), potassium ions (K⁺), and chlorine ions (Cl⁻) contained in a protective layer in contact with a metal artificial lattice film may be kept up to 10 ppm each.

As described above, a magneto-resistive element of this exemplary embodiment can be used in high-temperature and high-humidity environments, such as in an automobile, and even in environments of temperatures ranging from 150 to 200°C, which is a heat-resistant temperature of resin, e.g. polyimide, used for an extended period of time.

### INDUSTRIAL APPLICABILITY

A magneto-resistive element of the present invention has no hysteresis and small deterioration of the characteristics even at high temperatures, and has excellent heat resistance and corrosion resistance. Thus, this element is useful for a sensor and the like used in severe environments, such as in an automobile.

## Claims

1. A magneto-resistive element comprising:
a substrate;
a metal artificial lattice film in which a magnetic thin film and a non-magnetic metal thin film are alternately laminated in at least two layers on a part of this substrate and formed into a predetermined pattern;
a first protective layer covering the metal artificial lattice film on the substrate; and
a second protective layer formed on the first protective layer;
wherein residual stress of the first protective layer is substantially zero, and the second protective layer is made of a material rejecting water.

2. The magneto-resistive element of claim 1, wherein the magnetic thin film is made of an alloy containing nickel (Ni), iron (Fe) and cobalt (Co), and the non-magnetic metal thin film is made of one of cupper (Cu) and silver (Ag).

3. A magneto-resistive element comprising:
a substrate;
a metal artificial lattice film in which a magnetic thin film and a non-magnetic metal thin film are laminated in at least two layers on a part of this substrate and formed into a predetermined pattern; and
a protective layer covering the metal artificial lattice film on the substrate;
wherein the magnetic thin film contains nickel (Ni), iron (Fe), and cobalt (Co), and in percentage composition based on the number of atoms, nickel (Ni) ranges from 1 to 5 atomic%, cobalt (Co) ranges from 50 to 95 atomic %, and a residue is iron.

4. The magneto-resistive element of claim 3, wherein the magnetic thin film is an alloy film having a composition ratio based on the number of atoms of nickel (Ni): cobalt (Co): iron (Fe) = 4: 90: 6.

5. The magneto-resistive element of claim 3 or 4, wherein the non-magnetic metal thin film is made of one of cupper (Cu) and silver (Ag).

6. The magneto-resistive element of any one of claims 3 through 5, wherein the protective layer comprises a first protective layer formed on the substrate including the metal artificial lattice film, and a second protective layer formed on the first protective layer, residual stress of the first protective layer is substantially zero, and the second protective layer is made of a material rejecting water.

7. The magneto-resistive element of claim 1 or 6, wherein the first protective layer is made of one of silicon monoxide (SiO), silicon dioxide (SiO₂), silicon nitride (SiNx), and silicon oxynitride (SiON), and the second protective layer is made of polyimide.

8. The magneto-resistive element of any one of claims 1 through 4, wherein magnetic strain of the magnetic thin film is zero.

9. The magneto-resistive element of claim 1 or 3, wherein the substrate is made of ceramics.

10. The magneto-resistive element of claim 9, wherein the substrate is a glazed ceramic substrate having a glass glazed thereon, and the metal artificial lattice film is formed on the glass layer.

11. The magneto-resistive element of claim 10, wherein an amount of sodium ions (Na⁺), potassium ions (K⁺), and chlorine ions (Cl⁻) contained in the glass layer is up to 10 ppm each.

12. The magneto-resistive element of claim 1, 6, or 7, wherein an amount of sodium ions (Na⁺), potassium ions (K⁺), and chlorine ions (Cl⁻) contained in the first protective layer is up to 10 pmm each.

13. A method of manufacturing a magneto-resistive element comprising the steps of:
forming a metal artificial lattice film having a predetermined pattern in which a magnetic thin film and a non-magnetic metal thin film are alternately laminated in at least two layers on a part of a substrate;
forming a first protective layer covering the artificial lattice film on the substrate and having a residual stress of substantially zero; and
forming a water-rejecting second protective layer on the first protective layer.

14. The method of manufacturing a magneto-resistive element of claim 13, wherein the metal artificial lattice film is made of alternately laminating the magnetic thin film and the non-magnetic metal thin film, the magnetic thin film is an alloy made of nickel (Ni), cobalt (Co), and iron (Fe), in percentage composition based on the number of atoms, nickel (Ni) ranges from 1 to 5 atomic%, cobalt (Co) ranges from 50 to 95 atomic %, and a residue is iron, and the non-magnetic metal film is made of one of cupper (Cu) and silver (Ag).

15. The method of manufacturing a magneto-resistive element of claim 13, wherein the step of forming the first protective layer includes forming one of silicon monoxide (SiO), silicon dioxide (SiO₂), silicon nitride (SiNx), and silicon oxynitride (SiON) by one of sputtering and physical vapor deposition processes with a temperature of the substrate set in a range of 200 to 250°C.

16. The magneto-resistive element of claim 1 or 3, wherein the magneto-resistive element is used in an environment of at least 150°C.

17. A method of using a magneto-resistive element, wherein the magneto-resistive element of claim 1 or 6 is used in an environment of at least 150°C.
